# EUROPEAN PATENT APPLICATION

(11) **EP 4 546 404 A1**
(43) Date of publication of application: **30.04.2025**
(21) Application number: 24168608.8
(22) Date of filing: 05.04.2024
(51) Int. Cl.: H01L 21/74, H01L 23/528, H01L 23/535

(54) **BURIED INTERCONNECT TRAVERSING TRENCH ISOLATION**

(30) Priority: 26.10.2023 US 202318384138
(71) Applicant: GlobalFoundries U.S. Inc., Malta, NY 12020 (US)
(72) Inventor: BORISOV, Kiril B., 1700 Sofia (BG); ZIER, Manfred Michael, 01109 Dresden (DE); BACHER, Alexander S., Malta, NY, 12020 (US); PRITCHARD, David C., Malta, NY, 12020 (US); RAMADOUT, Benoit F. C., 01109 Dresden (DE)
(74) Representative: Lambacher, Michael

(57) **Abstract**

The present disclosure relates to semiconductor structures and, more particularly, to buried interconnect structures and methods of manufacture. The structure includes: a semiconductor substrate; a trench isolation structure extending into the semiconductor substrate; and at least one buried interconnect structure in the semiconductor substrate and crossing the trench isolation structure.

## Description

### BACKGROUND

The present disclosure relates to semiconductor structures and, more particularly, to buried interconnect structures and methods of manufacture.

In electronic design, wire routing is a step in the design of integrated circuits (ICs). The routing adds wires needed to properly connect components while obeying design rules for the integrated circuit.

Design rules vary considerably from layer to layer and from circuit to circuit. For example, the allowed width and spacing on the lower layers may be much smaller than the allowed widths and spacings on the upper layers. This introduces many complications. Also, technological routing density limitations might negatively impact latency in dense logic and memory blocks.

### SUMMARY

In an aspect of the disclosure, a structure comprises: a semiconductor substrate; a trench isolation structure extending into the semiconductor substrate; and at least one buried interconnect structure in the semiconductor substrate and crossing the trench isolation structure. Additional features of the structure are set forth in dependent claims 2 to 10.

In an aspect of the disclosure, a structure comprises: a semiconductor substrate; a trench isolation structure extending into the semiconductor substrate; a buried interconnect structure comprising a metal material, the buried interconnect structure located below a top surface of the semiconductor substrate and adjacent to the trench isolation structure; and a via interconnect structure contacting the buried interconnect structure and extending through the trench isolation structure.
Additional features of the structure are set forth in dependent claims 12 to 14.

In an aspect of the disclosure, a method comprises: forming a trench isolation structure extending into a semiconductor substrate; and forming at least one buried interconnect structure in the semiconductor substrate and crossing the trench isolation structure.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1A shows a top view of a buried interconnect structure, amongst other features, and respective fabrication processes in accordance with aspects of the present disclosure.
FIG. 1B shows a cross-sectional view of the buried interconnect structure of FIG. 1A, along line A-A.
FIG. 2 shows a buried interconnect structure, amongst other features, in accordance with additional aspects of the present disclosure.
FIG. 3 shows a buried interconnect structure, amongst other features, in accordance with further aspects of the present disclosure.
FIG. 4A shows a top view of a buried interconnect structure, amongst other features, in accordance with aspects of the present disclosure.
FIG. 4B shows a cross-sectional view of the buried interconnect structure of FIG. 4A, along line A-A.
FIG. 4C shows a cross-sectional view of the buried interconnect structure of FIG. 4A, along line B-B.
FIG. 5 shows a circuit view with buried interconnect structures, amongst other features, in accordance with aspects of the present disclosure.
FIG. 6 shows a logic cell with buried interconnect structures, amongst other features, in accordance with aspects of the present disclosure.
FIG. 7 shows a device with buried interconnect structures, amongst other features, in accordance with aspects of the present disclosure.
FIGS. 8A-8D show fabrication processes for manufacturing a buried interconnect structure in accordance with aspects of the present disclosure.

### DETAILED DESCRIPTION

The present disclosure relates to semiconductor structures and, more particularly, to buried interconnect structures and methods of manufacture. More specifically, the present disclosure relates to buried interconnect structures crossing trench isolation structures within a semiconductor substrate. Advantageously, the present disclosure provides improved routing density (e.g., by about 30 % over conventional schemes), reduced well resistance, and reduced gate resistance in dense logic and memory blocks, for example. The reduced gate resistance may be provided when the buried interconnect is routed parallel to gate lines. The reduced gate resistance also provides a beneficial latency reduction.

In more specific embodiments, the buried metal interconnect structures increase routing density, reduce latency in dense logic and memory blocks and decrease well resistances. The buried metal interconnect structures may be provided within a semiconductor substrate, below an active device. The active device may be, for example, a transistor. The buried interconnect structures may also cross a trench isolation structure. In embodiments, a via contact connects a back end of the line (BEOL) metal with the buried metal interconnect structure through, for example, the trench isolation structure.

The structures of the present disclosure can be manufactured in a number of ways using a number of different tools. In general, though, the methodologies and tools are used to form structures with dimensions in the micrometer and nanometer scale. The methodologies, i.e., technologies, employed to manufacture the structures of the present disclosure have been adopted from integrated circuit (IC) technology. For example, the structures are built on wafers and are realized in films of material patterned by photolithographic processes on the top of a wafer. In particular, the fabrication of the structures uses three basic building blocks: (i) deposition of thin films of material on a substrate, (ii) applying a patterned mask on top of the films by photolithographic imaging, (iii) etching the films selectively to the mask and (iv) implantation steps. In addition, precleaning processes may be used to clean etched surfaces of any contaminants, as is known in the art. Moreover, when necessary, rapid thermal anneal processes may be used to drive-in dopants or material layers as is known in the art.

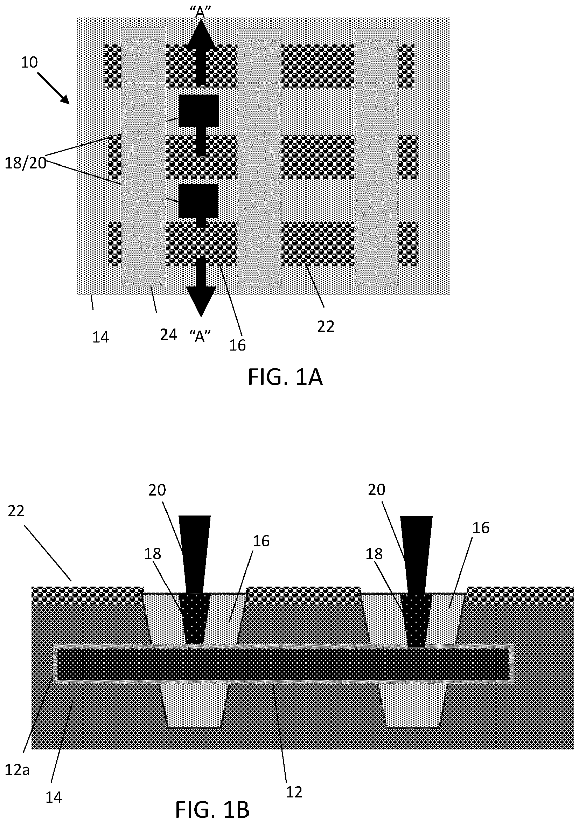

FIG. 1A shows a top view of a buried interconnect structure, amongst other features, and respective fabrication processes, and FIG. 1B shows a cross-sectional view of the buried interconnect structure of FIG. 1A. More specifically, and referring to FIGS. 1A and 1B, the structure 10 includes an interconnect structure 12 buried within a semiconductor substrate 14. In embodiments, the semiconductor substrate 14 may be a bulk semiconductor substrate or a semiconductor-on-insulator (SOI) substrate. The semiconductor substrate 14 may comprise any semiconductor material including, but not limited to Si. For example, the semiconductor substrate 14 may be composed of any suitable material including, but not limited to, Si, SiGe, SiGeC, SiC, GaAs, InAs, InP, and other III/V or II/VI compound semiconductors.

The buried interconnect structure 12 is below a top surface of the semiconductor substrate 14. In embodiments, the buried interconnect structure 12 can be approximately 150 nanometers below the surface of the semiconductor substrate 14; although other dimensions are contemplated herein. As should be understood by those of skill in the art, the buried interconnect structure 12 will improve, e.g., increase, routing density as the interconnect structure 12 is not within any of the FEOL or BEOL metal layers.

The buried interconnect structure 12 may be any conductive material. For example, the buried interconnect structure 12 may be tungsten or aluminum or ruthenium as examples. In alternative embodiments, the buried interconnect structure 12 may be other refractory metals or thermal stable metals. The buried interconnect structure 12 may also include, in embodiments, an optional dielectric liner 12a. The dielectric liner 12a may be an oxide material or other insulator material, e.g., nitride, etc.

As further shown in FIG. 1B, the buried interconnect structure 12 crosses over (e.g., extends through) a trench isolation structure 16. The trench isolation structure 16 may enclose or surround a portion of the buried interconnect structure 12. For example, the trench isolation structure 16 may be on sides surfaces and underneath (e.g., bottom surface) of the buried interconnect structure 12.

The trench isolation structure 16 can be formed by conventional lithography, etching and deposition methods known to those of skill in the art. For example, a resist formed over the semiconductor substrate 14 is exposed to energy (light) and developed utilizing a conventional resist developer to form a pattern (opening). An etching process with a selective chemistry, e.g., reactive ion etching (RIE), will be used to transfer the pattern from the resist layer to the semiconductor substrate 14 to form one or more trenches in the semiconductor substrate 14 through the openings of the resist. Following the resist removal by a conventional oxygen ashing process or other known stripants, an insulator material (e.g., SiO₂)can be deposited by any conventional deposition processes, e.g., chemical vapor deposition (CVD) processes. Any residual material on the surface of the semiconductor substrate 14 can be removed by conventional chemical mechanical polishing (CMP) processes.

A via interconnect 18 extends within the trench isolation structure 16 and physically and electrically contacts the buried interconnect structure 12. In embodiments the via interconnect 18 may be any conductive material to known to those of ordinary skill in the art such that no further explanation is required. For example, the via interconnect 18 may be tungsten, aluminum or other known metals as is known in the art. An upper via interconnect 20 may physically and electrically connect to the via interconnect 18. The upper via interconnect 20 may be tungsten, aluminum or other known metals as is known in the art. Although not shown, the upper via interconnect 20 may connect to upper wiring layers (BEOL wiring structures) provided in a particular routing scheme based on a desired design layout.

The trench isolation structure 16 may be located between active regions 22 of a device 24. By way of example, the device 24 may be a plurality of transistors, e.g., gate structures, as shown in FIG. 1A. The gate structures 24 may be, for example, finFET structures (e.g., gate lines) or planar structures provided on a bulk substrate or semiconductor-on-insulator substrate (SOI), e.g., semiconductor substrate 14. Also, in embodiments, the gate structures 24 may be fingers (e.g., gate lines) that extend on sides of the trench isolation structure 16. In embodiments, the gate structures 24 may include a low-k or high-k dielectric material and either polysilicon or workfunction metals or combinations thereof as is known in the art.

In embodiments, the active regions (e.g., structured fins) 22 may be raised source and drain regions adjacent to the gate structures 24. The source and drain regions 22 may be formed by an epitaxial growth process with an in-situ doping process or, alternatively, followed by an ion implantation process as are known in the art.

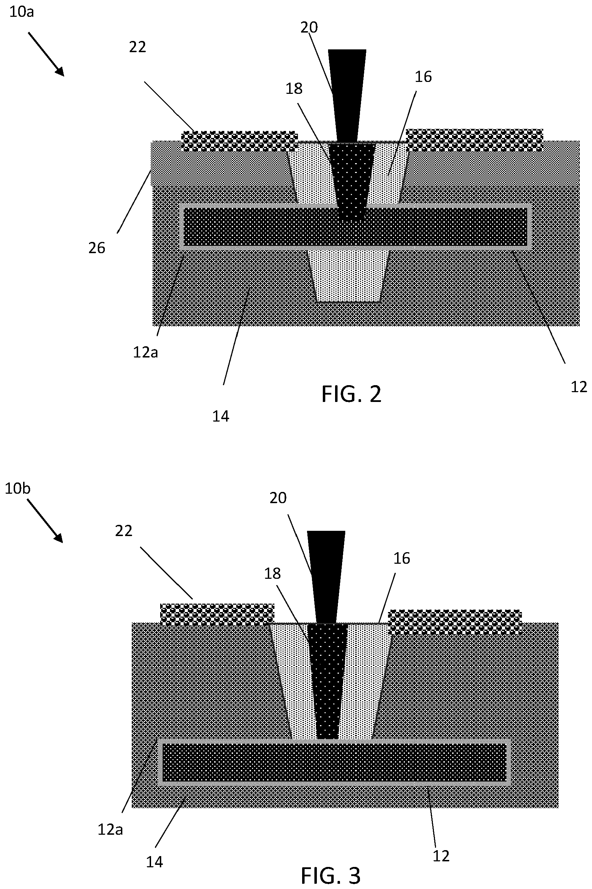

FIG. 2 shows a buried interconnect structure, amongst other features, in accordance with additional aspects of the present disclosure. In the structure 10a of FIG. 2, an epitaxial semiconductor material 26 may be formed on the surface of the semiconductor substrate 14. The buried interconnect structure 12 is thus below a surface of the semiconductor substrate 14 and the epitaxial semiconductor material 26. For example, the buried interconnect structure 12 can be approximately 50 nanometers below the top surface of the semiconductor substrate 14 and 150 nanometers below the top surface of epitaxial semiconductor material 26; although other dimensions are contemplated herein. In this way, a trench used to form the buried interconnect structure 12 in the semiconductor substrate 14 may be shallower in depth than in the structure 10 shown in FIGS. 1A and 1B, which, in turn, provides certain fabrication and electrical advantages such, as for example, a lower energy ion implantation process to form a trench used in the fabrication of the buried interconnect structure 12.

Still referring to FIG. 2, the epitaxial semiconductor material 26 may be formed, e.g., grown, subsequent to the formation of the buried interconnect structure 12. In embodiments, the epitaxial semiconductor material 26 may be Si; although other materials are also contemplated herein as described with respect to the semiconductor substrate 14. Also, in this embodiment, the buried interconnect structure 12 surrounds the trench isolation structure 16, e.g., on the sides; although other configurations as described herein are also contemplated by the present disclosure. For example, in this configuration, the buried interconnect structure 12 does not extend through the trench isolation structure 16. As such, in this embodiment, the trench isolation structure 16 is not contacting a bottom surface of the buried interconnect structure 12. The remaining features of the structure 10a are similar to the structure 10 shown in FIGS. 1A and 1B such that no further explanation is required for a complete understanding of the present disclosure.

FIG. 3 shows a buried interconnect structure, amongst other features, in accordance with further aspects of the present disclosure. In this structure 10b, the buried interconnect structure 12 is buried deeper into the semiconductor substrate 14. In this configuration, the trench isolation structure 16 does not extend below the buried interconnect structure 12. For example, the buried interconnect structure 12 can be approximately 300 nanometers below the surface of the semiconductor substrate 14, which allows the buried interconnect structure 12 to cross over at a bottom of the trench isolation structure 16. The remaining features of the structure 10b are similar to the structure 10 shown in FIGS. 1A and 1B such that no further explanation is required for a complete understanding of the present disclosure.

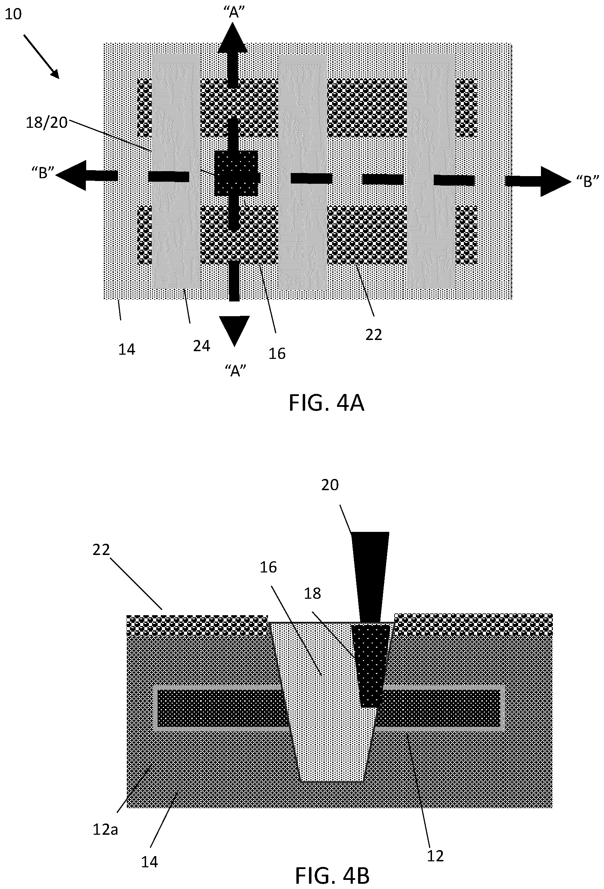

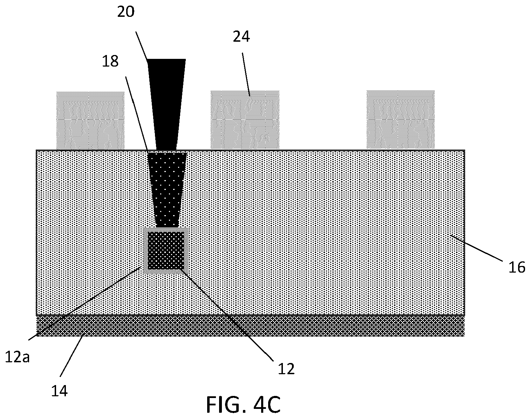

FIG. 4A shows a top view of a buried interconnect structure, amongst other features, and FIG. 4B shows a cross-sectional view of the buried interconnect structure of FIG. 4A along line A-A and FIG. 4C shows a cross-sectional view of the buried interconnect structure of FIG. 4A, along line B-B. In the structure 10c shown in FIGS. 4A-4C, the buried interconnect structure 12 surrounds the trench isolation structure 16. More specifically, the buried interconnect structure 12 will stop at the boundaries of the trench isolation structure 16. As in each of the embodiments, the trench isolation structure 16 may include tapered profile, such that in the configuration shown in FIGS. 4A and 4B, the buried interconnect structure 12 will stop at the tapered sidewalls of the trench isolation structures 16. The via interconnect 18 also extends partly within the trench isolation structure 16 and physically and electrically contacts the buried interconnect structure 12. The via interconnect 20 may also extend over the gate structures 24 as shown in FIG. 4A. The remaining features of the structure 10c are similar to the structure 10 shown in FIGS. 1A and 1B such that no further explanation is required for a complete understanding of the present disclosure.

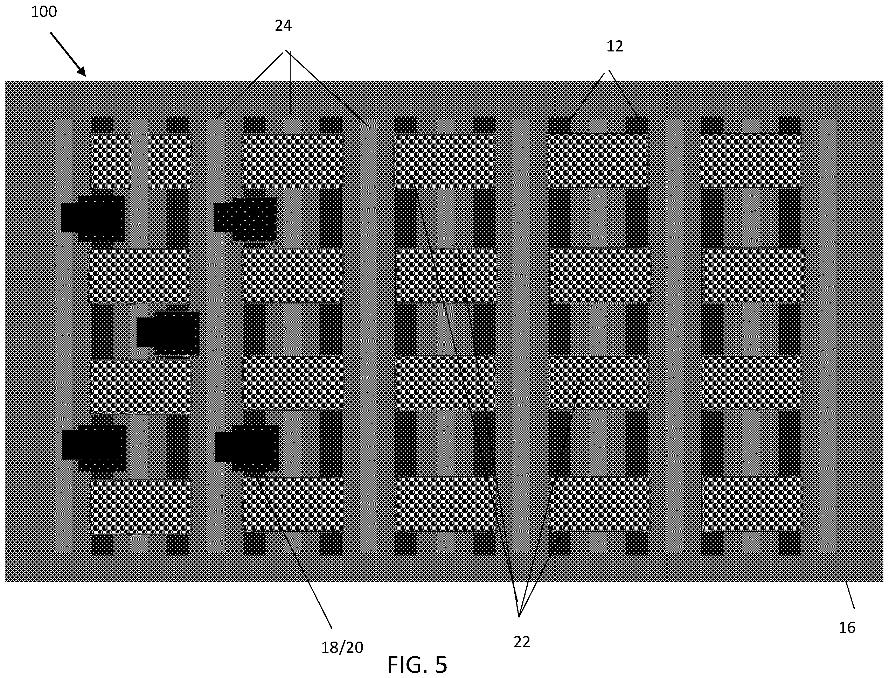

FIG. 5 shows a circuit 100 with buried interconnect structures 12, amongst other features, in accordance with aspects of the present disclosure. In embodiments, the circuit 100 may be part of a dense logic or memory blocks. The circuit 100 includes long continuous gate structures 24, e.g., finFETs or gate lines, located adjacent to the active regions 22. The buried interconnect structures 12 are provided within the semiconductor substrate 14, positioned between and parallel to the long continuous gate structures 24. The buried interconnect structures 12 can be strapped to the gate structures 24 by the via interconnects 18, 20, resulting in a lowered resistance and decreased latency.

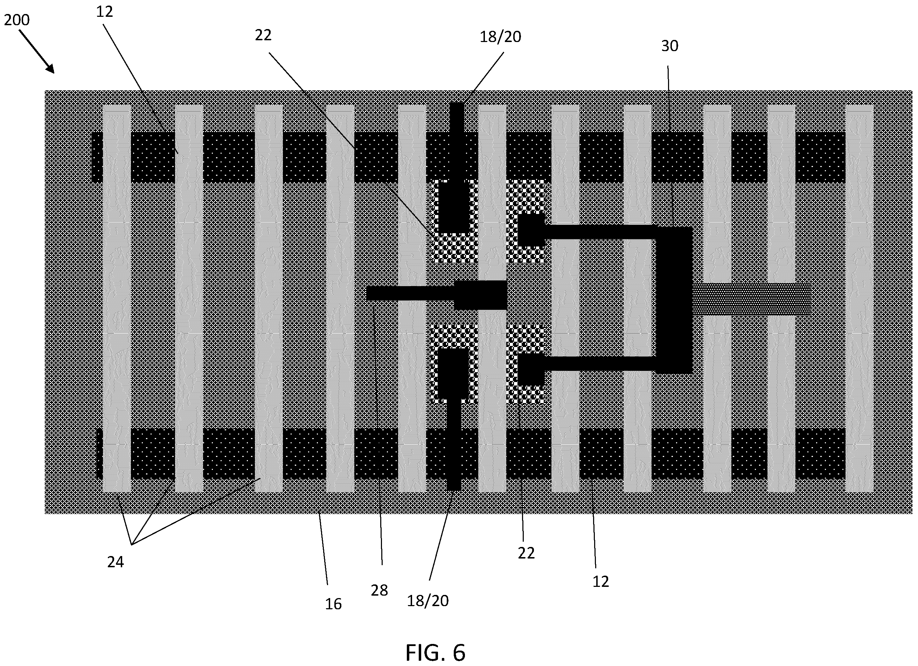

FIG. 6 shows a logic cell 200 with buried interconnect structures 12, amongst other features, in accordance with aspects of the present disclosure. In embodiments, the logic cell 200 may be representative of an inverter. In the structure shown in FIG. 6, the buried interconnect structures 12 are Vdd and Vss lines, respectively. The buried interconnect structures 12 (Vdd and Vss) provide track height reduction of standard cell libraries. That is, the buried interconnect structures 12 (Vdd and Vss) decrease routing complexity as power/ground rails are no longer on the upper metal layers. In this configuration, wiring line 28 and out wiring line 30 may be provided to the active regions 22, and the via interconnects 18, 20 may electrically connect the buried interconnect structures 12 (Vdd and Vss) to the active regions 22.

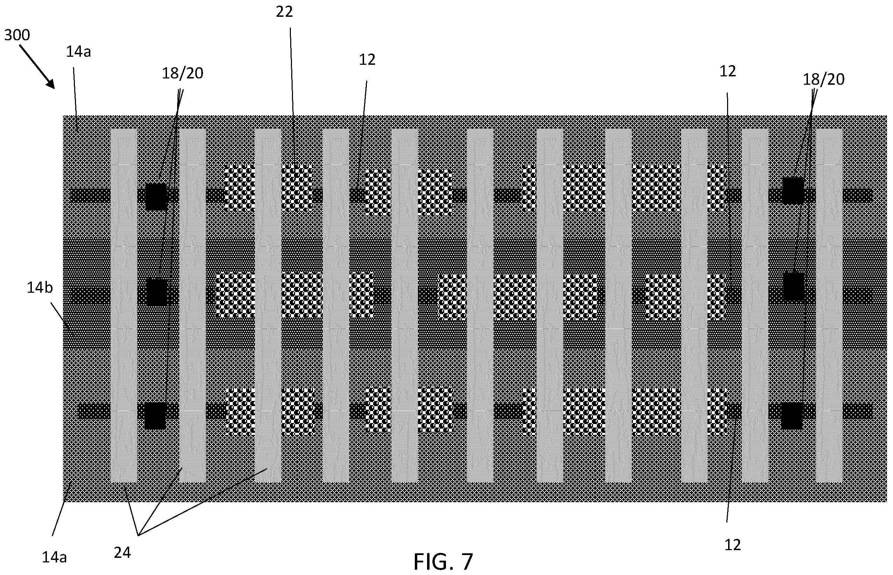

FIG. 7 shows a device 300 with the buried interconnect structures 12, amongst other features, in accordance with aspects of the present disclosure. In the device 300 of FIG. 7, the semiconductor substrate 14 may comprise fully depleted semiconductor on insulator technology. The semiconductor substrate 14 may comprise N-wells 14a and a P-well 14b between the N-wells 14a, with the gate structures 24, e.g., finFETs or gate lines, extending parallel to and over the N-wells 14a and the P-well 14b. The buried interconnect structures 12 may be provided in each of the N-wells 14a and the P-well 14b, running perpendicular to the gate structures 24. The via interconnects 18, 20 may be provided in each of the N-wells 14a and the P-well 14b at ends of the buried interconnect structures 12.

In the integration scheme of FIG. 7, for example, the buried interconnect structures 12 are galvanically connected to the P-well 14b between the N-wells 14a. Accordingly, the implementation of the buried interconnect structures 12 may reduce the well resistance and, hence, reduce the density of well taps. It should be understood by those of skill in the art that in conventional structures, well resistance requires well taps to be placed close to one another. In addition, the use of the buried interconnect structures 12 saves area because the connection to the N-wells 14a and the P-well 14b may be placed between adjacent gate structures 24.

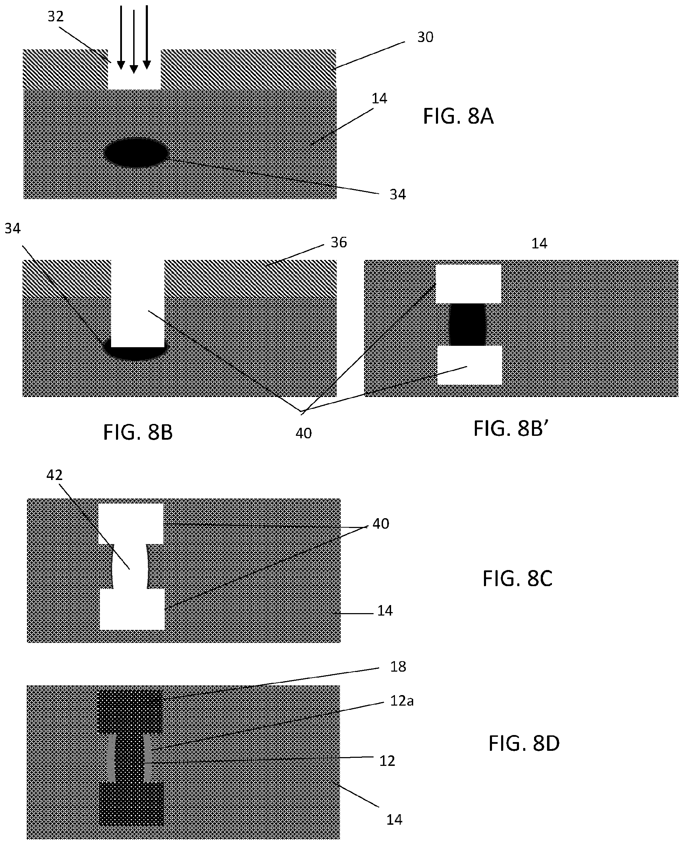

FIGS. 8A-8D show fabrication processes for manufacturing a buried interconnect structure in accordance with aspects of the present disclosure. FIGS., 8A and 8B are cross-sectional views of the build structure; whereas FIGS. 8B-8D are top down views of the build structure.

Referring to FIG. 8A, an implantation mask 30 is formed over the semiconductor substrate 14. The implantation mask 30 is patterned using conventional lithography and etching process to form an opening 32, which corresponds to selected exposed areas for forming a sacrificial region 34. The implantation mask may include a layer of a light-sensitive material, such as an organic photoresist, applied by a spin coating process, pre-baked, exposed to light projected through a photomask, baked after exposure, and developed with a chemical developer. The implantation mask has a thickness and stopping power sufficient to block masked areas against receiving a dose of the implanted ions.

An ion implantation is performed through the opening 32 of the implantation mask 30 followed by an annealing process, resulting in the sacrificial region (crystalline material) 34 deep into the semiconductor substrate 14. The sacrificial region 34 may be provided at a same depth as the buried interconnect structure, e.g., 50 to 300 nm in depth. The ion implantation may have a lower energy to form the sacrificial region 34 at a shallower location within the semiconductor substrate. In embodiments, the ion implantation may be, for example, N+, O+ or Ge+. The sacrificial region 34 may be, for example, SiN, SiO or SiGe, respectively (or other material that is selective to the semiconductor substrate 14).

In FIGS, 8B and 8B', the implantation mask is removed and a hardmask 36 is formed over the semiconductor substrate 14. In embodiments, openings 38 are formed in the hardmask 36. The openings 38 may be formed by conventional lithography and etching processes. A selective etch, e.g., RIE, is performed to form trenches 40 in the semiconductor substrate 14. The etching will stop on the sacrificial region 34.

In FIG. 8C, an air gap 42 is formed in the semiconductor substrate 14, connecting two of the trenches 40. In embodiments, the air gap 42 may be formed by a wet etch of the remaining sacrificial region, e.g., SiN material. In this way, a tunnel or air gap is formed under a surface of the semiconductor substrate 14, connected at its ends by the trenches 40. It should be understood that more than two trenches may be used to form the air gap 42.

In FIG. 8D, the air gap 42 is filled by a refractory metal to form the buried interconnect structure 12. In embodiments, a dielectric liner 12a may be deposited prior to the deposition of the refractory metal. In further embodiments, the refractory metal may also be used to form the via interconnect 18 within the trenches 40. The refractory metal may be formed by a conventional deposition process, e.g., chemical vapor deposition. The refractory metal may be, for example, nitrides with excellent fill factors such as TiN, TaN, or metallic materials, etc. The CVD gases should not result in a pinch off phenomena when the air gap 42 is several microns in dimension; although other fabrication processes and dimensions are contemplated herein.

The structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multi-chip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure comprising:
a semiconductor substrate;
a trench isolation structure extending into the semiconductor substrate; and
at least one buried interconnect structure in the semiconductor substrate and crossing the trench isolation structure.

2. The structure of claim 1, wherein the at least one buried interconnect structure comprises a metallic interconnect under an active device.

3. The structure of claim 1 or claim 2, wherein the at least one buried interconnect structure extends through the trench isolation structure, and, optionally, wherein the trench isolation structure is on sides and a bottom surface of the at least one buried interconnect structure.

4. The structure of claim 1 or claim 2, wherein the at least one buried interconnect structure surrounds the trench isolation structure.

5. The structure of one of claims 1 to 4, wherein the at least one buried interconnect structure is below a top surface of the semiconductor substrate, and, optionally, wherein the structure further comprises an epitaxial semiconductor material over the semiconductor substrate.

6. The structure of one of claims 1 to 5, further comprising a via interconnect structure extending through the trench isolation structure from a top side, the via interconnect structure contacting the at least one buried interconnect structure.

7. The structure of one of claims 1 to 6, further comprising active regions and at least one gate structure between the active regions, wherein the at least one buried interconnect structure is perpendicular to the active regions and parallel to the gate structure.

8. The structure of one of claims 1 to 7, wherein the at least one buried interconnect structure comprises a Vss line and a Vdd line electrically strapped to active regions.

9. The structure of one of claims 1 to 8, wherein the semiconductor substrate comprises an N-well and a P-well and the buried interconnect structures extend within the N-well and the P-well, and, optionally, wherein the semiconductor substrate comprises a fully depleted semiconductor on insulator material.

10. The structure of one of claims 1 to 8, wherein the semiconductor substrate comprises bulk semiconductor material.

11. A structure comprising:
a semiconductor substrate;
a trench isolation structure extending into the semiconductor substrate;
a buried interconnect structure comprising a metal material, the buried interconnect structure located below a top surface of the semiconductor substrate and adjacent to the trench isolation structure; and
a via interconnect structure contacting the buried interconnect structure and extending through the trench isolation structure.

12. The structure of claim 11, wherein the metal material of the buried interconnect structure comprises a refractory metal, and/or wherein the buried interconnect structure is provided at a bottom of the trench isolation structure.

13. The structure of claim 11 or claim 12, wherein the buried interconnect structure extends through the trench isolation structure, or wherein the buried interconnect structure surrounds the trench isolation structure.

14. The structure of one of claims 11 to 13, further comprising an epitaxial semiconductor material over the semiconductor substrate, the trench isolation structure extending through the epitaxial semiconductor material and the semiconductor substrate.

15. A method comprising:
forming a trench isolation structure extending into a semiconductor substrate; and forming at least one buried interconnect structure in the semiconductor substrate and crossing the trench isolation structure.
